Europäisches Patentamt

European Patent Office

Office européen des brevets

(19)

(11) EP 0 685 932 B1

(12) FASCICULE DE BREVET EUROPEEN

(45) Date de publication et mention
de la délivrance du brevet:
**30.09.1998 Bulletin 1998/40**

(51) Int Cl.⁶: **H03F 3/21**

(21) Numéro de dépôt: **95401111.0**

(22) Date de dépôt: **12.05.1995**

(54) **Amplificateur à plusieurs étages à transistors en cascade et à puissance de sortie ajustable**

Mehrstufiger Transistorverstärker in Kaskade mit einstellbarer Ausgangsleistung

Amplifier with transistorised multiple stages in cascade and adjustable output power

(84) Etats contractants désignés:
**DE FR GB IT**

(30) Priorité: **31.05.1994 FR 9406599**

(43) Date de publication de la demande:
**06.12.1995 Bulletin 1995/49**

(73) Titulaire: **THOMSON-CSF**
**75008 Paris (FR)**

(72) Inventeurs:
• **Eudeline, Philippe**
**F-92402 Courbevoie Cedex (FR)**
• **Peyrat, André**
**F-92402 Courbevoie Cedex (FR)**
• **Sipma, Jean-Pierre**
**F-92402 Courbevoie Cedex (FR)**

(74) Mandataire: **Beylot, Jacques et al**
**Thomson-CSF Propriété Intellectuelle,**
**13, Avenue du Président Salvador Allende**
**94117 Arcueil Cédex (FR)**

(56) Documents cités:
EP-A- 0 473 299     DE-A- 2 904 011
US-A- 4 091 380     US-A- 5 126 688
US-A- 5 136 300

• PATENT ABSTRACTS OF JAPAN vol. 9 no. 288
(E-358) ,15 Novembre 1985 & JP-A-60 130207
(NIPPON DENSHIN DENWA KOSHA) 11 Juillet
1985,

## Description

La présente invention telle qu'elle est définie dans les revendications est relative au contrôle de la puissance émise par des émetteurs mettant en oeuvre des amplificateurs haute fréquence à plusieurs étages de transistors de puissance au silicium fonctionnant en classe C en régime impulsionnel.

Il est souvent utile de disposer d'une commande rapide de réglage du niveau de puissance émis par un émetteur d'impulsions, le délai de réaction étant de l'ordre de la milliseconde pour passer d'un niveau de puissance à un autre. Un exemple où cela s'avère utile est celui du radar secondaire qui a pour rôle d'interroger les avions présents dans son voisinage à l'aide d'un code à impulsions afin de les identifier et de connaître leurs positions. Dans un radar secondaire on doit pouvoir modifier rapidement la puissance d'émission afin de contrôler le nombre de réponses. Cette technique dénommée " chuchotement - cri " ou, en langue anglaise, " whisper - shout " permet d'améliorer la qualité de la détection et de supprimer un grand nombre de réponses parasites indésirables tout en réduisant les pollutions mutuelles entre stations de radar secondaire.

Plusieurs méthodes ont été utilisées dans l'art antérieur pour obtenir une puissance réglable en sortie d'un amplificateur haute fréquence à plusieurs étages de transistors fonctionnant en classe C en régime impulsionnel. Le document US-A- 5 126 688 donne un exemple d'amplificateur où la puissance est commandée en agissant sur plusieurs étages.

La méthode la plus immédiate consiste à intercaler des atténuateurs à commande électronique en sortie de l'amplificateur. Elle a pour inconvénient majeur de rajouter des pertes qu'il faut compenser en augmentant la puissance de sortie de l'amplificateur car les atténuateurs présentent des pertes même quand ils sont dans l'état d'atténuation minimale. De plus le nombre de pas d'atténuation est limité et lié à la quantité d'atténuateurs. L'augmentation de la puissance de sortie de l'amplificateur destinée à compenser les pertes des atténuateurs entraîne des augmentations de coût, de volume et de poids qui viennent s'ajouter à celles dues à l'insertion de l'atténuateur lui-même.

Une autre méthode consiste à mettre à profit le fait que la puissance de sortie est obtenue en général en sommant les signaux de sortie de plusieurs étages fonctionnant en parallèle pour obtenir une baisse de la puissance de sortie par extinction d'un ou de plusieurs de ces étages. Une telle méthode est décrite par exemple dans le brevet américain US-A-4311965. Cette méthode ne permet d'obtenir qu'un nombre limité de niveaux de puissance de sortie répartis de manière irrégulière. En effet si N est le nombre d'étages mis en parallèle et P le nombre d'étages éteints on montre que l'atténuation obtenue sur le niveau du signal de sortie par l'extinction de P des N étages est donnée par la formule :

$$A(dB) = 20\log\left(\frac{N-P}{N}\right)$$

Ainsi pour N égal à quatre on pourra réaliser les atténuations suivantes :

- pour P = 0        A = -0 dB
- pour P = 1        A = -2,5 dB
- pour P = 2        A = -6 dB
- pour P = 3        a = -12 dB

De même pour N égal à huit on pourra réaliser les atténuations: -0 dB; -1,16 dB; -2,5 dB; -4 dB; -6 dB; -8,5 dB; -12 dB et -18 dB. Cette répartition est trop irrégulière pour convenir dans la plupart des cas.

Il est par ailleurs connu que l'on peut faire varier la puissance de sortie d'un amplificateur de puissance fonctionnant en classe C en faisant varier sa tension d'alimentation. Cependant cette méthode n'est pas utilisée en pratique avec les amplificateurs à plusieurs étages en cascade car la plage de variation possible pour la tension de polarisation est limitée supérieurement par des problèmes de saturation et inférieurement par des problèmes d'instabilité. Ainsi si l'on joue globalement sur la tension de polarisation de plusieurs étages en cascade ou sur celle d'un seul étage l'on n'obtient qu'une plage réduite de variation de niveau de puissance, de l'ordre de 5 à 10 décibels ce qui est insuffisant pour la plupart des cas pratiques.

La présente invention a pour but un contrôle de la puissance de sortie d'un amplificateur à plusieurs étages de transistors en cascade par l'intermédiaire des tensions de polarisation de ses étages qui se fasse sur une large plage, d'une manière régulière.

Elle a également pour but un amplificateur à plusieurs étages de transistors en cascade et à puissance de sortie ajustable sur une large plage, de conception simple et ayant le meilleur rendement possible lorsqu'il est utilisé à pleine puissance.

Elle a pour objet un procédé de réglage de la puissance de sortie d'un amplificateur à plusieurs étages à transistors en cascade fonctionnant en classe C en régime impulsionnel consistant à faire varier simultanément et de manière échelonnée les tensions de polarisation de différents étages à transistor, la variation relative de tension de polarisation d'un étage augmentant avec son rang par rapport au sens d'amplification.

Avantageusement, la variation relative de tension de polarisation d'un étage à transistor placé au n ième rang dans la chaîne des étages de l'amplificateur par rapport au sens d'amplification est prise égale à n fois la variation relative de tension de polarisation du premier étage.

Cette progression des variations relatives des tensions de polarisation en fonction de la position des étages à transistor le long de la chaîne d'amplification est rendue possible, sans risque d'oscillations, par les changements progressifs des niveaux de puissance des signaux d'excitation d'entrée des étages résultant des effets additionnés des modifications de tension de polarisation des étages placés en amont dans la chaîne d'amplification. Elle permet d'élargir nettement la plage de variation de puissance de sortie par rapport à ce que l'on obtient en agissant globalement sur la tension de polarisation de tous les étages ou sur celle d'un seul étage.

L'invention a également pour objet un amplificateur de puissance à plusieurs étages à transistors en cascade fonctionnant en classe C en régime impulsionnel, mettant en oeuvre le procédé précité.

D'autres caractéristiques et avantages de l'invention ressortiront ci après de la description d'un mode de réalisation donné à titre d'exemple. Cette description sera faite en regard du dessin dans lequel :

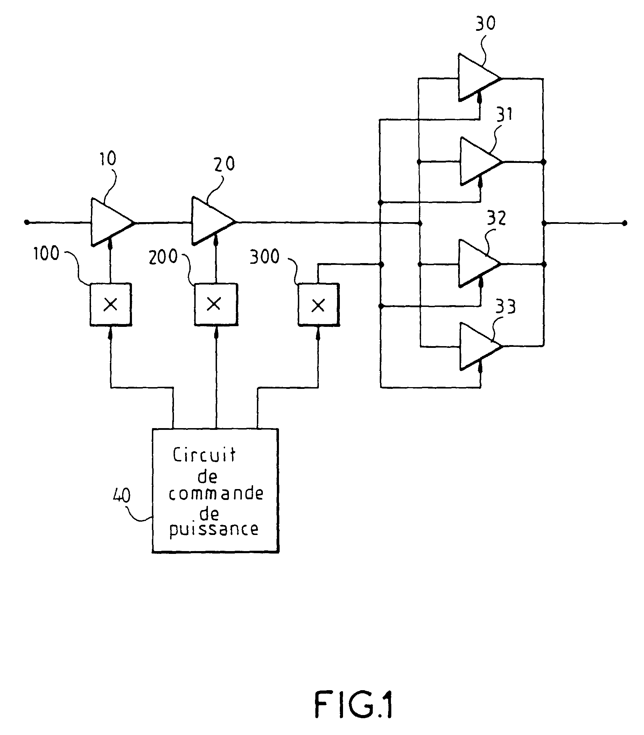

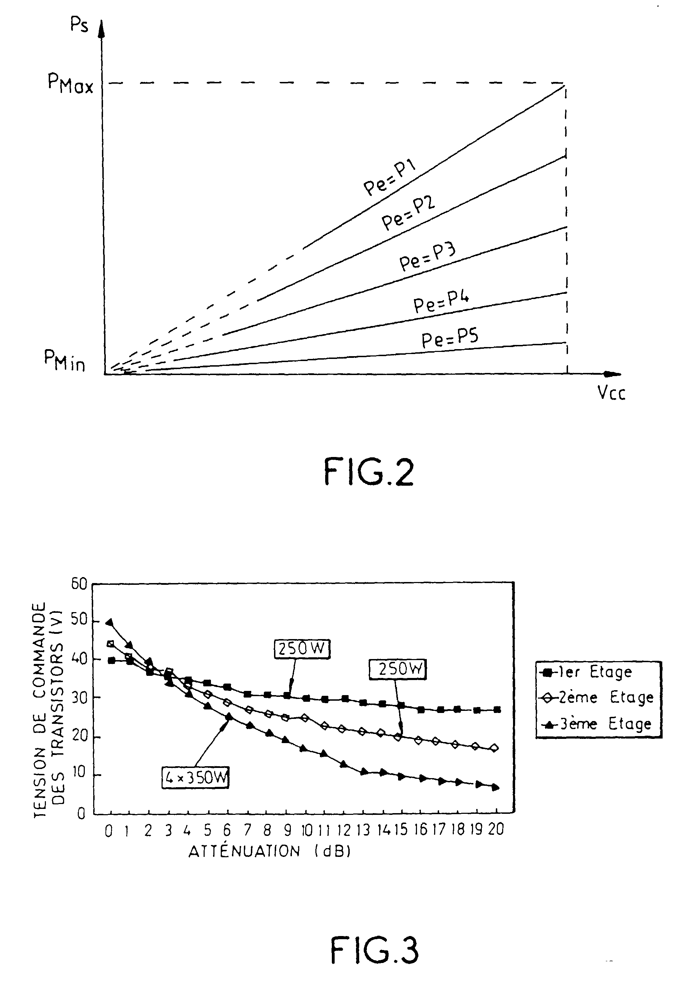

- une figure 1 représente un schéma d'un amplificateur de puissance haute fréquence à trois étages à transistors en cascade conforme à l'invention ;
- une figure 2 est un diagramme de courbes exprimant la variation de puissance de sortie qu'il est possible d'obtenir d'un transistor de puissance au silicium fonctionnant en haute fréquence, en fonction de sa tension de polarisation pour différentes puissances d'excitation d'entrée ; et
- une figure 3 est un diagramme de courbes exprimant les tensions de polarisation selon l'invention des trois étages de l'amplificateur de la figure 1 en fonction du niveau d'atténuation désiré.

On distingue sur la figure 1 un amplificateur de puissance haute fréquence à trois étages en cascade de transistors au silicium, à puissance de sortie continûment réglable dans une large plage. Celui-ci comporte deux premiers étages 10, 20 formés chacun d'un simple transistor de puissance et un troisième étage formé de la mise en parallèle de quatre transistors de puissance 30, 31, 32 et 33. Chaque étage est alimenté par un circuit individuel de polarisation réglable 100, 200, 300 commandé par un circuit de commande de puissance 40.

Les différents transistors sont des transistors au Silicium. Les transistors des deux premiers étages d'entrée 10,20 sont dimensionnés pour délivrer une puissance unitaire de 250 Watts et les transistors du troisième étage 300 une puissance unitaire de 350 Watts.

Les circuits individuels de polarisation réglable 100, 200, 300 sont des convertisseurs numérique-analogique qui délivrent des tensions analogiques correspondant à des valeurs numériques de consigne fournies par le circuit de commande de puissance 40.

Le circuit de commande de puissance 40 est une mémoire numérique renfermant une table des valeurs des tensions de polarisation à appliquer à chacun des trois étages de l'amplificateur en fonction de la puissance de sortie désirée.

Les transistors haute fréquence de puissance au silicium des trois étages de l'amplificateur fonctionnent en classe C en régime impulsionnel. Pour fonctionner correctement dans ce régime, sans saturation ni instabilité, ils doivent avoir une tension de polarisation maintenue dans une certaine plage qui dépend de leur puissance d'excitation d'entrée. Plus précisément, comme cela apparaît sur les courbes de la figure 2, cette plage de tension de polarisation est limitée supérieurement, pour des problèmes de saturation, par une valeur maximale quasiment constante et, inférieurement, pour des problèmes d'instabilité, par une valeur minimale qui augmente avec la puissance d'excitation d'entrée. Sur la figure 2 les courbes P1, P2, P3, P4, P5 représentent la variation de la puissance de sortie qu'il est possible d'obtenir d'un transistor haute fréquence de puissance au silicium, en classe C, en régime impulsionnel, à puissance d'excitation d'entrée constante, en fonction de la tension de polarisation, pour des puissances d'excitation d'entrée décroissantes (P1>P2>P3>P4>P5). La partie gauche en pointillés des courbes représente la zone d'instabilité tandis que la partie droite en trait plein représente la zone stable.

Ainsi, si l'on se contente de faire varier la tension de polarisation d'un seul étage, en pratique le dernier, on ne peut le faire que sur une plage réduite et l'on n'obtient qu'une variation de quelques décibels de la puissance de sortie de l'amplificateur. On améliore les choses en faisant varier globalement la tension de polarisation de tous les étages de l'amplificateur sans dépasser pour autant une plage de variation de puissance de sortie pour l'amplificateur d'une dizaine de décibels.

Pour vaincre cette limitation on propose, avec le schéma d'amplificateur de la figure 1, de faire varier séparément les tensions de polarisation des différents étages en cascade de l'amplificateur pour profiter de l'abaissement de la limite inférieure de la plage de variation de la tension de polarisation d'un étage qui résulte de la diminution de sa puissance d'excitation d'entrée provoquée par la baisse des tensions de polarisation du ou des étages amont. On obtient alors une plage de variation de la puissance de sortie de l'amplificateur beaucoup plus importante pouvant atteindre 20 décibels ce qui est un gros progrès. C'est ainsi que pour des transistors haute fréquence de puissance au silicium de 250 et 350 Watts ayant une tension de polarisation maximale de l'ordre de 90 Volts on a pu obtenir des valeurs d'atténuation de la puissance de sortie de l'amplificateur régulièrement espacées de 0 à 20 décibels, en polarisant les trois étages de l'amplificateur selon les valeurs données par le tableau suivant :

| TENSION DE POLARISATION DES TRANSISTORS | | | |
|---|---|---|---|
| Atténuation (dB) | 1er Etage | 2éme Etage | 3éme Etage |
| 0 | 40 | 44 | 50 |
| 1 | 40 | 41 | 44 |
| 2 | 37 | 38 | 39 |
| 3 | 36 | 37 | 34 |
| 4 | 35 | 33 | 31 |
| 5 | 34 | 31 | 28 |
| 6 | 33 | 29 | 25 |
| 7 | 31 | 27 | 23 |
| 8 | 31 | 26 | 21 |
| 9 | 31 | 25 | 19 |
| 10 | 30 | 25 | 17 |
| 11 | 30 | 23 | 16 |
| 12 | 30 | 22 | 13 |
| 13 | 29 | 21,5 | 11 |
| 14 | 29 | 21 | 11,5 |
| 15 | 28 | 20 | 10,5 |
| 16 | 27 | 19 | 10 |
| 17 | 27 | 19 | 09 |
| 18 | 27 | 18 | 08,5 |
| 19 | 27 | 17,5 | 08 |
| 20 | 27 | 17 | 07 |

Les différentes valeurs de ce tableau ont permis de tracer le diagramme de courbes de la figure 3 qui donne un aperçu des variations relatives des tensions de polarisation des trois étages de l'amplificateur en fonction de l'atténuation de puissance de sortie recherchée. Ces courbes peuvent être modélisées par une formule polynomiale de la forme :

$$V_n = V_{n,4}x^4 + V_{n,3}x^3 + V_{n,2}x^2 + V_{n,1}x + V_{n,0}$$

n étant le rang de l'étage par rapport au sens d'amplification, $V_n$ la tension de polarisation à appliquer à l'étage n exprimée en Volts, $V_{n,j}$ des coefficients et x l'atténuation en décibels.

Pour le premier étage cette formule polynomiale vaut :

$$V_1 = -\frac{7}{1500}x^3 + \frac{3}{20}x^2 - \frac{61}{30}x + 40$$

Elle est valable pour x compris entre 0 et 15 Volts. Au-delà, c'est à dire entre 16 et 20 Volts, il faut la remplacer par $V_1$ ( égal à 27 Volts quel que soit x compris entre 16 et 20 décibels.

Pour le deuxième étage elle vaut :

$$V_2 = \frac{1}{15000}x^4 - \frac{3}{500}x^3 + \frac{119}{600}x^2 - \frac{69}{20}x + 44$$

Pour le troisième étage elle vaut :

$$V_3 = \frac{1}{3000}x^4 - \frac{7}{375}x^3 + \frac{53}{120}x^2 - \frac{371}{600}x + 50$$

On peut également exprimer plus simplement ces variations de tension de polarisation en fonction de l'atténuation de puissance de sortie recherchée en observant que la variation relative de tension de polarisation appliquée au deuxième étage de l'amplificateur est environ deux fois celle appliquée au premier étage et que la variation relative de tension de polarisation appliquée au troisième étage est environ trois fois celle appliquée au premier étage. Le tout se résume alors dans les deux formules suivantes :

$$\frac{\Delta V_2}{V_2} = 2 * \frac{\Delta V_1}{V_1} \qquad \text{et} \qquad \frac{\Delta V_3}{V_3} = 3 * \frac{\Delta V_1}{V_1}$$

ce qui s'écrit également :

$$\frac{\Delta V_1}{V_1} = \frac{1}{3} * \frac{\Delta V_3}{V_3} \qquad \text{et} \qquad \frac{\Delta V_2}{V_2} = \frac{2}{3} * \frac{\Delta V_3}{V_3}$$

Ainsi, en imposant aux différents étages en cascade d'un amplificateur de puissance haute fréquence à transistors au silicium des variations relatives de tension de polarisation échelonnées proportionnelles à leur rang dans la chaîne d'amplification, on peut obtenir une large plage de réglage du niveau de puissance de sortie.

En fait la loi de proportionnalité précédente n'est qu'approximative et doit être complétée par un ajustement expérimental des valeurs calculées pour s'adapter aux caractéristiques particulières du montage et des composants utilisés. Mais son existence donne au concepteur les moyens de contrôler la puissance de sortie de l'amplificateur sur une plage étendue en déterminant à coup sûr et rapidement les tensions de polarisation à appliquer aux différents étages pour chaque valeur de puissance de sortie souhaitée.

Pour la détermination des tensions de polarisation des différents étages d'un amplificateur on commence par déterminer les valeurs nominales correspondant à la puissance de sortie maximale en ayant pour souci d'optimiser le rendement collecteur des différents transistors amplificateurs et d'égaliser leur gain en puissance tout en restant dans une plage de fonctionnement stable. Ensuite on diminue de A% la tension de polarisation du troisième étage, de deux tiers de A% la tension de polarisation du deuxième étage et de un tiers de A% la tension de polarisation du premier étage. On retouche éventuellement faiblement les tensions de polarisation des premier et deuxième étages pour optimiser la stabilité. On essaye différentes valeurs pour A et on note les tensions de polarisation utilisées pour les trois étages et l'atténuation de puissance de sortie obtenue par rapport au niveau de puissance nominale. On obtient ainsi un tableau analogue à celui donné précédemment que l'on inscrit dans une mémoire morte constituant le circuit de commande de puissance pilotant les convertisseurs numérique-analogique des circuits individuels de polarisation des différents étages.

L'important est que la loi de proportionnalité permet d'aller directement au voisinage immédiat des bonnes valeurs de tension de polarisation pour les différents étages de l'amplificateur. Cela évite de passer à côté de la bonne combinaison, ce qui est un gros risque lorsque l'on procède par tâtonnements.

C'est ainsi que pour obtenir le tableau précédent des tensions de polarisation des trois étages de l'amplificateur de la figure 1 on a procédé selon les étapes suivantes :

- détermination des valeurs des tensions de polarisation pour la puissance nominale de 1 kW ce qui a donné : $V_1$=40 Volts, $V_2$=44 Volts et $V_3$=50 Volts ;

- diminution de $V_3$ de 75% et corrélativement $V_2$ de 50% et $V_1$ de 25%. Les nouvelles valeurs sont respectivement 12,5 Volts, 22 Volts et 30 Volts. La baisse de puissance constatée en sortie de l'amplificateur est d'environ 12 dB. Après retouches pour parfaire le fonctionnement, les valeurs de tensions de polarisation retenues pour les trois étages sont respectivement de 13 Volts, 22 Volts et 30 volts (13 iéme ligne du tableau) ;

- diminution avec d'autres valeurs de pourcentage jusqu'à l'obtention d'une correspondance suffisamment étroite entre les différentes valeurs d'atténuation souhaitées et les triplets de tensions de polarisation. Dans l'exemple du tableau précédent on a essayé des valeurs de pourcentage de diminution suffisamment proche pour être capable de faire varier le niveau de puissance de sortie de l'amplificateur de 0 à 20 dB avec un pas de 1 dB.

Avec le schéma de réalisation de la figure 1 la rapidité de réglage des tensions de polarisation peut être inférieure à la microseconde ce qui permet d'agir sur la forme même des impulsions émises pour corriger des temps de montée et de descente ou pour compenser des baisses de puissance à l'intérieur des impulsions liées à l'échauffement des transistors de puissance sur la durée même des impulsions.

Cette méthode d'ajustement de la puissance de sortie d'un amplificateur de puissance à plusieurs étages de transistors en cascade fonctionnant en haute fréquence en classe C, en faisant varier simultanément et de manière échelonnée les tensions de polarisation de différents étages peut se combiner avec l'autre méthode consistant à éteindre dans un étage un ou plusieurs éléments fonctionnant en parallèle. On obtient alors une plage de variation de puissance de sortie encore plus grande sans l'inconvénient de cette dernière méthode puisque l'on a déjà une possibilité de réglage par pas aussi étroits que l'on désire.

## Revendications

1. Procédé de réglage de la puissance de sortie d'un amplificateur haute fréquence à plusieurs étages (10,20,30,31,32,33) de transistors en cascade fonctionnant en classe C en régime impulsionnel caractérisé en ce qu'il consiste à faire varier simultanément et de manière échelonnée les tensions de polarisation de différents étages à transistor, la variation relative de tension de polarisation d'un étage augmentant avec son rang par rapport au sens d'amplification.

2. Procédé selon la revendication 1, caractérisé en ce que la variation relative de tension de polarisation d'un étage à transistor placé au n ième rang dans la chaîne des étages de l'amplificateur par rapport au sens d'amplification est prise égale à n fois la variation relative de tension de polarisation du premier étage.

3. Amplificateur à plusieurs étages à transistors en cascade et à puissance de sortie ajustable caractérisé en ce qu'il comporte pour chaque étage des circuits individuels réglables de polarisation (100, 200, 300) et un circuit de commande de puissance (40) pilotant les circuits individuels réglables de polarisation (100, 200, 300) en fonction du niveau de puissance recherché en sortie de l'amplificateur de manière à leur imposer des variations relatives de tension de polarisation différentes augmentant avec le rang de l'étage considéré compté par rapport au sens d'amplification.

4. Amplificateur selon la revendication 3, caractérisé en ce que ledit circuit de commande de puissance (40) est une mémoire numérique stockant pour chaque niveau de puissance de sortie de l'amplificateur un groupe de valeurs de consigne de tension de polarisation destinées aux circuits individuels réglables de polarisation (100, 200, 300) et en ce que les circuits individuels réglables de polarisation (100, 200, 300) sont des convertisseurs numérique-analogique.

## Patentansprüche

1. Verfahren zur Regelung der Ausgangsleistung eines Hochfrequenzverstärkers mit mehreren Transistorstufen (10, 20, 30, 31, 32, 33) in Kaskadenschaltung, die in Klasse C und Impulsbetrieb arbeiten, dadurch gekennzeichnet, daß es darin besteht, gleichzeitig und gestuft die Vorspannungen verschiedener Transistorstufen zu variieren, wobei die relative Veränderung der Vorspannung einer Stufe mit ihrem Rang in Richtung der Verstärkung zunimmt.

2. Verfahren nach Anspruch 1, dadurch gekennzeichnet, daß die relative Veränderung der Vorspannung einer Transistorstufe, die in der Kette der Stufen des Verstärkers in Verstärkungsrichtung den n-ten Rang einnimmt, der n-fachen relativen Veränderung der Vorspannung der ersten Stufe gleichgesetzt wird.

**3.** Verstärker mit mehreren Transistorstufen in Kaskadenschaltung und mit justierbarer Ausgangsleistung, dadurch gekennzeichnet, daß er für jede Stufe einzelne regelbare Vorspannungsschaltungen (100, 200, 300) und eine Leistungssteuerschaltung (40) aufweist, die die einzelnen regelbaren Vorspannungsschaltungen (100, 200, 300) abhängig vom gewünschten Leistungspegel am Ausgang des Verstärkers so steuert, daß sie unterschiedlichen relativen Vorspannungsveränderungen unterliegen, die mit dem Rang der betreffenden Stufe bezüglich der Verstärkungsrichtung zunehmen.

**4.** Verstärker nach Anspruch 3, dadurch gekennzeichnet, daß die Leistungssteuerschaltung (40) ein digitaler Speicher ist, der für jeden Leistungspegel am Ausgang des Verstärkers eine Gruppe von Sollwerten der Vorspannung speichert, die für die verschiedenen regelbaren Vorspannungsschaltungen (100, 200, 300) bestimmt sind, und daß die einzelnen regelbaren Vorspannungsschaltungen (100, 200, 300) Digital-Analogwandler sind.

## Claims

**1.** Process for adjusting the output power of a highfrequency amplifier with several cascaded transistor stages (10, 20, 30, 31, 32, 33) operating in class C in pulse mode, characterized in that it consists in simultaneously varying the bias voltages of the different transistor stages in a stepped manner, the relative variation in the bias voltage of a stage increasing with its rank with respect to the direction of amplification.

**2.** Process according to Claim 1, characterized in that the relative variation in the bias voltage of a transistor stage placed at the nth rank in the chain of stages of the amplifier with respect to the direction of amplification is taken equal to n times the relative variation in the bias voltage of the first stage.

**3.** Amplifier with several cascaded transistor stages and with adjustable output power, characterized in that it includes, for each stage, individual adjustable bias circuits (100, 200, 300) and a power control circuit (40) driving the individual adjustable bias circuits (100, 200, 300) on the basis of the power level sought at the output of the amplifier so as to impose thereon different relative variations in bias voltage which increase with the rank of the relevant stage reckoned with respect to the direction of amplification.

**4.** Amplifier according to Claim 3, characterized in that the said power control circuit (40) is a digital memory which stores, for each output power level of the amplifier, a group of bias voltage set-point values intended for the individual adjustable bias circuits (100, 200, 300) and in that the individual adjustable bias circuits (100, 200, 300) are digital/analog converters.

FIG.1

FIG.2

FIG.3